Europäisches Patentamt

European Patent Office

Office européen des brevets

(19)

(11) Publication number: **0 303 370**
**A2**

(12) ## EUROPEAN PATENT APPLICATION

(21) Application number: **88306917.1**

(22) Date of filing: **27.07.88**

(51) Int. Cl.⁴: **H05K 3/00**

(30) Priority: **14.08.87 US 85508**

(43) Date of publication of application:
**15.02.89 Bulletin 89/07**

(84) Designated Contracting States:
**DE GB NL**

(71) Applicant: **SEDCO SYSTEMS, INC.**
**65 Marcus Drive**
**Melville New York 11747(US)**

(72) Inventor: **Oak, Kevin J.**
**4 Dover Court**
**Holbrook New York 11741(US)**
Inventor: **Patchen, Michael S.**
**1142 Udall Road**
**Bayshore New York 11706(US)**

(74) Representative: **Jackson, David Spence et al**
**REDDIE & GROSE 16, Theobalds Road**
**London, WC1X 8PL(GB)**

(54) **Circuit board component spacer.**

(57) A spacer member (14) for electrical components (16), especially small-diameter components (such as resistors, diodes, and capacitors) is mounted on a printed circuit board (12). Where the printed circuit board (12) has a first hole (30) disposed therethrough, the walls of such first hole comprising electrically conducting material, the spacer (14), which comprises an electrically insulating member, has a second hole (28) disposed therethrough. The first and second holes (30,28) are in substantial alignment, the walls of the second hole (28) comprising electrically insulating material. The electrical component (16) is disposed on the spacer member (14), with a lead (22) comprising a stress bend portion (24) and an end portion (26) disposed through the first and second holes (30,28). The end portion (26) can be soldered to the walls of the first hole (30) with the solder being substantially prevented from "wicking" up the component lead (22) to the stress bend portion (24) of the lead by the electrically insulating spacer member (14), and specifically by the electrically insulated walls of the second hole (28).

FIG. 3

## CIRCUIT BOARD COMPONENT SPACER

### Background of the Invention

The present invention relates to circuit board assemblies and more particularly to circuit board assemblies having relatively small components mounted thereon.

As is known in the art, circuit boards such as printed circuit boards (PCB's) often have individual components such as resistors, diodes, and capacitors mounted thereon. Typically, the components lie flat on the upper surface of the printed circuit board with the leads thereof extending outward from the component horizontally to the PCB, making a 90 degree downward bend and extending through solder plated holes in the printed circuit board. Such bend is often referred to as a "stress bend". The leads are typically soldered in the solder plated through holes. While such arrangement is satisfactory in some applications, often the solder which secures the lead within the through holes flows or "wicks" up the component lead through the solder plated printed circuit board through hole and into the stress bend of the lead. The solder is generally less flexible than the lead itself. Thus, in applications wherein the printed circuit board assembly is subjected to large temperature variations and mechanical forces, the solder in the stress bend, rather than flexing with the lead, cracks causing failures in the electrical connections to the component lead. For this reason, in military applications, military standards (such as MIL-STD 454, WS6536, or MIL-STD 2000) generally prohibit printed circuit board assemblies from having solder connections with solder wicked into the stress bends of any components thereon. Hence, such solder connections must be reworked to remove the solder from each stress bend. Such reworking is time consuming and labor intensive.

Thus, it is an object of the present invention to provide a printed circuit board assembly wherein wicking of the solder into stress bends of individual component leads is substantially prevented.

### Summary of the Invention

In accordance with the present invention, a substrate is provided with a component disposed over a surface of the substrate, the component comprising a lead disposed through a hole in the substrate. A member is disposed between the component and the surface of the substrate, the lead being disposed through the member. With such arrangement, the component lead may be soldered to the walls of the hole in the substrate with the solder being substantially prevented from wicking into a stress bend of the lead by the member disposed between the component and the surface of the substrate.

In a preferred embodiment of the present invention, a printed circuit board is provided having a first hole disposed therethrough with the walls of said first hole comprising electrically conducting material. An electrically insulating member having a second hole disposed therethrough is disposed on the printed circuit board with the first and second holes being in substantial alignment, the walls of the second hole comprising electrically insulating material. A component is disposed on the member, the component having a lead comprising a stress bend portion and an end portion, the end portion of the lead being disposed through the first and second holes. With such arrangement, the end portion of the component lead may be soldered to the walls of the first hole with the solder being substantially prevented from "wicking" up the component lead to the stress bend portion of the lead by the electrically insulating member, and specifically by the electrically insulated walls of the second hole of such member.

### Brief Description of the Drawings

The foregoing features of the present invention and the advantages thereof may be fully understood from the following detailed description read in conjunction with the accompanying drawings wherein:

FIG. 1 is a partial top plan view of a printed circuit board assembly according to the present invention;

FIG. 2 is a cross sectional view taken along lines 2-2 in FIG. 1 of a component mounted on the printed circuit board assembly of FIG. 1; and

FIG. 3 is an enlarged cross sectional view of a portion of FIG. 2.

### Description of the Preferred Embodiment

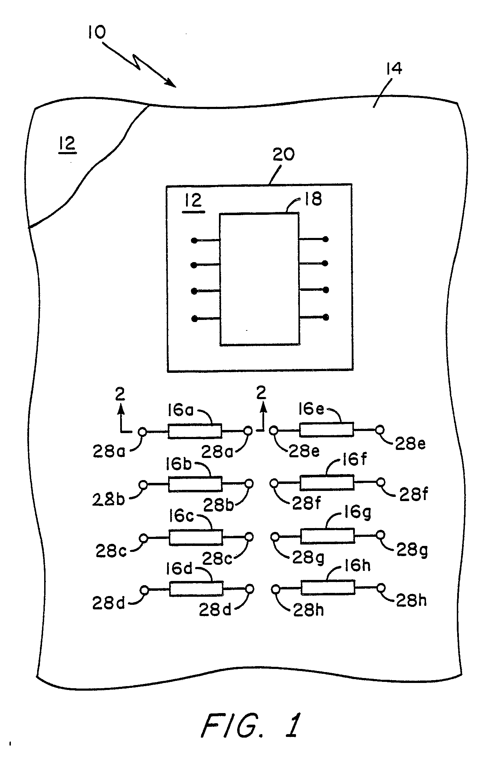

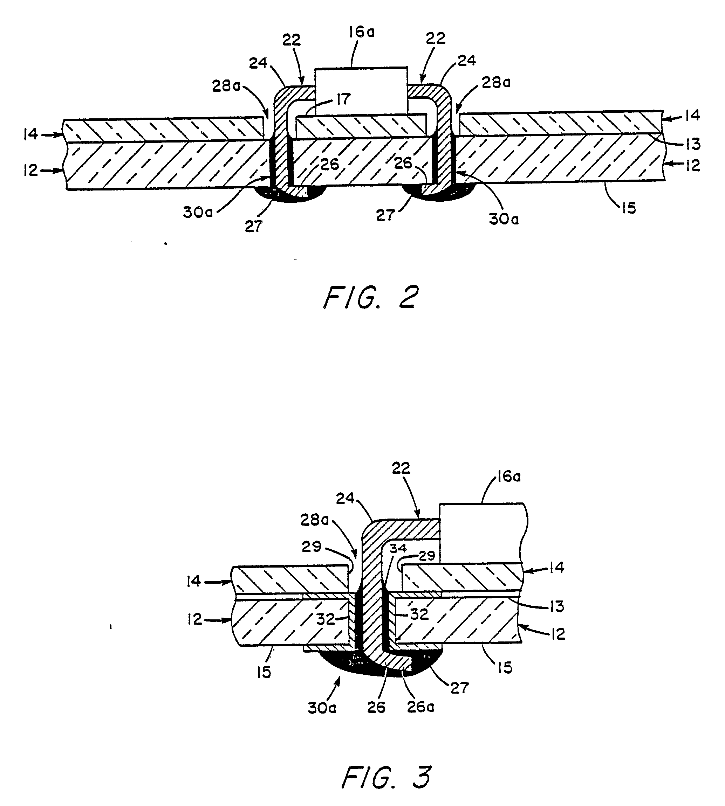

Referring to FIGS. 1-3, a circuit board assembly 10 in accordance with a preferred embodiment of the present invention is shown to comprise circuit board 12, here a printed circuit board (PCB) over which are disposed insulating spacer member 14 and a plurality, here eight, of components 16a-16h. Here, an integrated circuit package 18 is also disposed on PCB 12, as shown. Components 16a-16h are disposed on an upper surface of insulating spacer member 14, as shown in FIG. 2 for representative component 16a. Integrated circuit 18 is here disposed directly on an upper surface of PCB 12 through an opening 20 disposed in insulating spacer member 14, as shown in FIG. 1.

Printed circuit board 12 is here a conventional circuit board having a thickness of about 0.063 inches and provided with a plurality of through holes disposed therein from upper surface 13 to lower surface 15 thereof for receiving the leads of components 16a-16h and integrated circuit 18. For example, a pair of holes 30a are disposed through PCB 12 for receiving the leads 22 of component 16a, as shown in FIG. 2. Component 16a may comprise, for example, a resistor, glass diode or capacitor, and here is preferably a small diameter device, such as a conventional 1/8 watt resistor (the diameter of which is about 0.062 inches), for reasons to be explained. Component 16a here has a pair of leads 22, each lead having a length of approximately 0.14 inches and comprising a first portion 24 which comprises a stress bend and a second or end portion 26 which is secured by solder 27 within through hole 30a and also to lower surface 15 of PCB 12 (FIG. 3). That is, each lead 22 here extends horizontally outward from component 16a generally parallel to PCB 12 and is bent substantially 90 degrees downward through stress bend 24 to pass through hole 30a in PCB 12, with end portion 26 of such lead 22 being secured to PCB 12 by solder 27. As is known, stress bend 24 typically is disposed a minimum of two lead diameters from the component. Here, the diameter of leads 22 is substantially 0.015 inches in accordance with the aforementioned relatively small, 1/8 watt resistor. It is here noted that typically the diameter of PCB holes 30a is about 0.031 inches and thus it is noted that PCB holes 30a are substantially larger than component leads 22.

Spacer member 14 here comprises electrically insulating material, such as commercially available G-10 material, although other suitable insulating material may be substituted therefor. Spacer member 14 is disposed on upper surface 13 of PCB 12 between components 16a-16h and PCB upper surface 13, with components 16a-16h being disposed on an upper surface 17 of spacer member 14. Spacer member 14 is secured to the upper surface 13 of PCB 12 by any appropriate means, such as by epoxying spacer member 14 to PCB 12. Spacer member 14 may be provided with any suitable thickness, the limits of such thickness being determined on the one hand by the amount of spacing desired between component 16a and PCB upper surface 13 to substantially prevent wicking of solder 27 into lead stress bend portion 24, as will be discussed, the thickness of spacer member 14 being limited on the other hand by any restrictions on the height of components above PCB 12 imposed in a given application. Here, the thickness of spacer member 14 is between 0.02 and 0.062 inches and preferably between 0.040 and 0.062 inches. Most preferably, here insulating spacer member 14 has a thickness of about 0.05 inches. Referring again to FIG. 1, spacer member 14 has a plurality of pairs of holes 28a-28h disposed therethrough for components 16a-16h, respectively. Also disposed in spacer member 14 is an opening 20 within which integrated circuit 18 is here disposed to lie directly on upper surface 13 of PCB 12. Referring to FIG. 2, it is seen that through holes 28a for component 16a are disposed in overlaying relationship with through holes 30a of PCB 12, as shown. Thus, it may be appreciated that spacer member through hole pairs 28a-28h are aligned with corresponding PCB through hole pairs. Here, spacer member through holes 28a-28h (for example, holes 28a) are slightly larger (here by about 0.01 inches) than the diameter of the PCB holes (for example, holes 30a) to thereby allow some play in the alignment of spacer member through holes 28a-28h over such PCB through holes. Thus, as shown in FIG. 2, each lead 22 of component 16a is disposed through spacer member through hole 28a and PCB through hole 30a and is secured within PCB through hole 30a and to the lower surface 15 of PCB 12 by solder 27.

As may be seen in the enlarged view of FIG. 3, the walls of each PCB 12 through hole (for example, holes 30a) are conventionally metallized with solder plating 32 to facilitate securing component leads 22 within such holes 30a by solder 27. Solder plating 32 may also be coupled via printed circuitry (not shown) on PCB 12 to similarly solder plated PCB through holes for components 16b-16h and integrated circuit 18 to thereby provide electrical coupling between component 16a and such other components 16b-16h or integrated circuit 18. To put it another way, the walls of the PCB through holes comprise electrically conductive material. However, the walls 29 of spacer member through holes 28a-28h are not solder plated or otherwise metallized and thus comprise electrcially insulating material (such as the aforementioned G-10 material). Alternately stated, walls 29 of spacer member 14 through holes 28a, for example, comprise non-electrically conducting material.

As shown in FIG. 3, end portion 26 of lead 22 is soldered to solder plating 32 within PCB through hole 30a and to PCB lower surface 15 with solder 27. Due to the size differential between PCB hole 30a and lead 22, sufficient space exists between lead 22 and solder plating 32 for such solder to flow through PCB hole 30a and up lead 22 to thereby produce a solder wick 34, as shown. As discussed, if solder wick 34 becomes disposed in lead stress bend 24 portion, when printed circuit board assembly 10 is subjected to mechanical forces, such solder wick 34 would substantially impede stress bend portion 24 of component lead 22 from flexing. Thus, solder connection 27 possibly would crack and become dislodged from either lead 22 or solder plating 32, thereby impairing or breaking the electrical connection between lead 22 and solder plating 32 and possibly producing an electrical malfunction in printed circuit board assembly 10. For this reason, the aforementioned military standards prohibit the presence of solder in sterss bends, requiring labor intensive rework of solder connections found to have solder disposed in component stress bends. Such "wicking" of solder 27 into stress bend 24 is substantially prevented from occurring in the present invention by the presence of insulating spacer member 14 between component 16a (for example) and PCB 12, and hence between the stress bend portion 24 of lead 22 and solder plated PCB through hole 30a. As discussed, the walls 29 of spacer member 14 through holes 28a comprise electrically insulating material (such as G-10 material) rather than electrically conductive material (such as solder plating 32). It has been found that solder 27 tends to flow up those portions of lead 22 which are adjacent to other electrically conductive material (such as solder plating 32 along the walls of PCB through holes 30a). However, solder wicking is found to be substantially prevented for portions of lead 22 disposed adjacent to electrically insulating material (such as walls 29 of spacer member through holes 28a). That is, the electrically insulating walls 29 of the through holes (such as through hole 28a) of spacer member 14 are found to substantially prevent solder 27 from wicking above through hole 28a, and hence above upper surface 17 of spacer member 14, thereby substantially preventing solder wick 34 from becoming disposed within the stress bend 24 portion of component lead 22. Thus, component lead stress bend portion 24 is free to flex in response to mechanical forces without placing additional stress on solder connection 27, thereby maintaining the electrical connection between component lead 22 and solder plating 32. Hence, the aforementioned military standards are complied with, thereby substantially reducing the amount of rework required for such solder connections.

It has further been found that the above-discussed prevention of solder 27 wicking into component lead stress bend portion 24 is optimized as the elevation of component 16a above PCB upper surface 13 is increased. However, as discussed, PCB 12 is here about 0.063 inches thick and component leads 22 are about 0.14 inches in length, thereby limiting the maximum thickness of insulating spacer member 14. Here, the thickness of insulating spacer member 14 (0.05 inches) is selected to be substantially equal to the thickness of PCB 12 (0.063 inches), thereby providing maximum spacing between component 16a and PCB upper surface 13 while allowing a sufficient portion of component lead end portion 26 to extend through PCB hole 30a.

It is noted that commercially available components 16a-16h typically have leads with regions 26a of end portions 26 which are pre-tinned to facilitate a solder connection thereto. The spacing between such components 16a-16h and PCB upper surface 13 provided by insulating spacer member 14 makes it more likely that such pre-timed lead end portion 26a will be disposed adjacent to solder plating 32 to thus facilitate an electrical connection with solder 27 between component lead end portion 26 and solder plating 32.

Referring again to FIG. 1, as discussed, integrated circuit 18 is here disposed directly on upper surface 13 of printed circuit board 12 through an opening 20 disposed in insulating spacer member 14. Typically, the leads (not numbered) of integrated circuit packages such as package 18 do not include stress bends; therefore, such typical inte grated circuit package 18 need not be mounted on insulating spacer member 14. Additionally, if the height of one or more of components 16a-16h requries that such component be mounted directly on upper surface 13 of printed circuit board 12, insulating spacer member 14 may be cut out or relieved in the area of such component.

Having described preferred embodiments of the present invention, modifications and alterations thereto may become apparent to those of ordinary skill in the art. For example, insulating spacer member 14, rather than comprising a single member disposed between a plurality of components (16a-16h) and a circuit board, may alternately comprise a plurality of individual spacer members disposed between such circuit board and corresponding individual components 16a-16h and the leads 22 thereof. Thus, it is understood that the present invention is to be limited only by the scope of the appended claims.

### Claims

1. In combination:
(a) a circuit board having a hole disposed therethrough;

(b) a component disposed over a surface of the circuit board, said component comprising a lead disposed through the circuit board hole and secured to the circuit board; and

(c) an insulating material member disposed between the surface of the circuit board and the component.

2. The combination of Claim 1 wherein the circuit board hole has walls comprising an electrically conductive material, and further comprising: means for electrically and mechanically securing said component lead to the electrically conductive material of the walls of the circuit board hole.

3. The combination of Claim 2 wherein said insulating material member comprises an upper surface disposed adjacent to the component and the component lead comprises a first portion disposed above said upper surface and a second portion disposed within the circuit board hole, said insulating material member having a thickness selected to substantially prevent said electrical and mechanical securing means from becoming disposed on the first portion of the component lead.

4. The combination of Claim 3 wherein the circuit board has a nominal thickness, said predetermined thickness of the insulating material member being substantially equal to said nominal thickness.

5. The combination of Claim 4 wherein the insulating material member has a hole disposed therethrough, the component lead being disposed through said hole disposed in the insulating material member.

6. In combination:

(a) a substrate having a first hole disposed therethrough with an electrically conductive material being disposed on walls of said first hole;

(b) a member having a second hole disposed therethrough, the second member being disposed on a surface of the substrate with the first and second holes in substantial alignment, walls of the second hole comprising electrically insulating material; and

(c) a component disposed on the member, the component comprising a lead disposed through the first and second holes and secured to the walls of said first hole.

7. The combination of Claim 6 wherein said member comprises an upper surface disposed adjacent to the component, said component lead comprising a first portion disposed above said upper surface and a second portion disposed within said first hole, said combination further comprising: means for electrically and mechanically securing the second portion of the component lead to the electrically conductive material disposed on the walls of the first hole, said member having a thickness selected to substantially prevent said electrical and mechanical securing means from becoming disposed on the first portion of the component lead.

8. In combination:

(a) substrate;

(b) a component disposed over a first surface of the substrate, the component comprising a lead, a first portion of the lead being disposed over the first surface and a second portion of the lead pasing through the substrate and being soldered to a second surface of the substrate; and

(c) means, disposed between the first surface and the component, for spacing the component from the first surface a predetermined amount selected to substantially prevent the solder from becoming disposed on the first portion of the component lead.

FIG. 1

FIG. 2

FIG. 3